# EUROPEAN PATENT APPLICATION

(11) **EP 1 962 425 A2**
(43) Date of publication of application: **27.08.2008**
(21) Application number: 08380044.1
(22) Date of filing: 19.02.2008
(51) Int. Cl.: H03K 17/955

(54) **Proximity sensor system**

(30) Priority: 20.02.2007 ES 200700438
(71) Applicant: Agotek Desarrollo Tecnologico, S.L., 48011 Bilbao (ES)
(72) Inventor: Mikel, Garrido Diez, 48007 Bilbao (ES); Gatto, Fernando, 48004 Bilbao (ES)
(74) Representative: Urteaga Simarro, José Antonio

(57) **Abstract**

A proximity sensor system (1) comprising a proximity sensor device (3) and a conductive area (5) external to the device, the latter being able to increase the sensibility (and therefore the operating range) of the proximity sensor device (3) with high effectiveness and low cost. The external conductive area (5) can be of any size, shape or configuration, although preferably comprising a structural support (4) that is connected to the proximity sensor device (3) in such a way that the conductive area (5) becomes connected to the conductive element (6) of the proximity sensor device (3). The conductive area (5) then acts as an extension of the aforementioned conductive element (6), therefore allowing to obtain a long-range proximity sensor system (1) at a reasonable price.

## Description

### Technical field

The invention relates to a proximity sensor system that can be used in many applications, for example as a security system designed to protect works of art (paintings, sculptures, etc.).

### Prior art

Works of art on display in museums or exhibition rooms are exposed to all kinds of negative actions by the world that surrounds them. Negative actions can be both voluntary (robberies, attacks, etc.) and involuntary (damage to works of art caused by people touching them or getting close to them, etc). For this reason, many art protection systems are known in the state of the art.

For example, systems that protect works of art using simple physical barriers such as rails, ropes, fences, etc. are known. Obviously, these protection systems are cheap, but not secure enough when faced with particularly harmful actions (vandalism, robbery, etc.). Other more advanced, and therefore more expensive, protection systems are known, such as laser-based or volumetric-based protection systems. Laser-based systems include a number of laser beams surrounding the work of art and control the continuity of the laser beams, so that if anyone comes close to the work of art, at least one laser beam is broken and an alarm is set off. Volumetric-based systems detect movement and changes in temperature.

This invention aims to provide a proximity sensor system that operates as a security system to protect works of art (among other uses), offering a high level of protection similar to that provided by the safest known sensors. At the same time, the invention aims to have a lower cost than the aforementioned safest known sensors.

### Brief description of the invention

The object of the invention is a proximity sensor system comprising two basic elements: a proximity sensor device and a conductive area external to the device that is able to increase the proximity sensor device's sensitivity (and therefore the operating range) with high levels of effectiveness and at a low cost. The proximity sensor device in accordance with the invention is a compact electronic device, small and transportable, one of whose components is a proximity sensor that works by detecting an electric variation in a conductive element contained in the device. The external conductive area can be of any size, shape or configuration; however, it is preferably comprised in a structural support connected to the proximity sensor device in such a way that the conductive area is connected to the proximity sensor device's conductive element, operating as an extension of the aforementioned conductive element. As a result, the proximity sensor has an effective conductive element that is made up of the device's conductive element and the conductive area, and which therefore offers a greater operating range than initially provided by the conductive element. If the structural support and the conductive area, as seen later on, are produced in accordance with the invention's preferred embodiments (which are low-cost embodiments), it is possible to obtain a long range proximity sensor system at a reasonable price.

The proximity sensor system according to the invention offers additional advantages. Firstly, there is no need to carry out preparation work or remodelling in the facility in order to install the device (other well-known systems do require remodelling). Secondly, the proximity sensor system is easy to transport (the proximity sensor device can be disconnected from the structural support and both elements can be transported separately). The easily-transportable nature of the invention is enhanced by the fact that no remodelling is required to be able to install the system, and by the fact that the system is applied individually on each work of art (unlike conventional systems, which would be extremely expensive if applied individually to each work of art and which therefore usually cover full rooms or large areas). An additional advantage of the system is that it is very flexible, in other words, it can be used in different applications (the proximity sensor device is always the same, whereas the structural support can change depending on each particular application).

### Brief description of the figures

The details of the invention can be seen in the attached non-limiting figures:
- Figure 1 is a diagram showing a first embodiment of the proximity sensor system according to the invention.
- Figure 2 is a more detailed diagram of the proximity sensor device and the structural support, according to the preferred embodiment of the invention.
- Figure 3 shows an application using a second embodiment of the proximity sensor system according to the invention.
- Figure 4 shows an embodiment of the structural support's conductive area according to the invention.
- Figure 5 illustrates another embodiment of the structural support's conductive area according to the invention.
- Figure 6 shows a perspective view of the preferred embodiment of the system according to the invention, featuring an exploded view of the proximity sensor device.
- Figure 7 is a view of the previous system, the proximity sensor device having been assembled.

### Detailed description of the invention

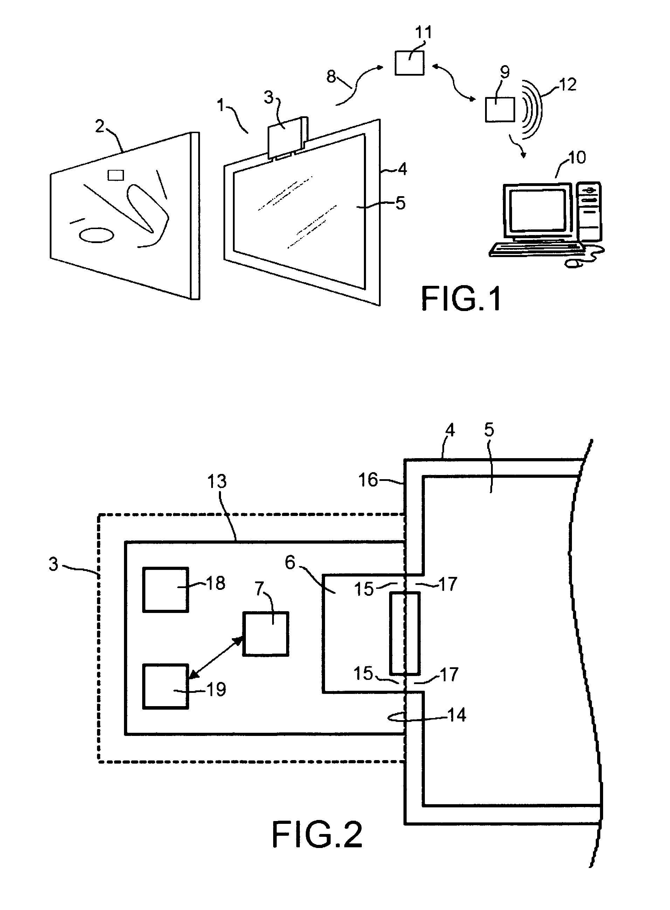

Figure 1 illustrates an embodiment of a proximity sensor system (1) according to the invention, used in the protection of a painting (2). The proximity sensor system (1) according to the invention comprises a proximity sensor device (3), which includes an internal proximity sensor (7) and a conductive element (6) -not visible-. The conductive element (6) is, for example, a conductive surface on top of a Printed Circuit Board (PCB). The proximity sensor (7) detects an electrical variation in the conductive element (6), the electrical variation being caused by the proximity of an object or person to the conductive element (6), and therefore to the painting (2).

When the proximity sensor device (3) detects a sufficient electric variation, it concludes that there is an object or person near the painting (2) and it carries out some kind of operation designed to prevent damage to the painting (2): it emits an alarm (e.g., using an internal buzzer), it sends an alarm signal to remote control equipment, or it performs any other applicable action. For example, as illustrated in Figure 1, the proximity sensor device (3) transmits an alarm signal (8) to a receiver (9), which emits an alarm sound signal (12) and transmits the alarm information to a remote computer (10). Another example, which is not illustrated, would be that the proximity sensor device (3) itself emitted some kind of alarm sound signal.

As can be seen in the figure, transmission is carried out on a wireless basis and may require one or more relay devices (11) in the event that the proximity sensor device (3) has a limited-range radio frequency transmitter. Radio frequency transmission is preferably achieved using a free RF channel. However, while this is the preferred embodiment of the invention, the invention is not restricted to free channel radio frequency systems; transmission can be undertaken using any other wireless communications system (Bluetooth, ZigBee, Wi-Fi, GSM, GRPS, etc.).

With the purpose of increasing the proximity sensor device's (3) operating range, the proximity sensor system (1) according to the invention also comprises a structural support (4) of a certain size containing a conductive area (5). The structural support (4) is connected to the proximity sensor device (3). In turn, the conductive area (5) is electrically connected to the conductive element (6) in such a way that the conductive area (5) operates as an extension of the conductive element (6). The proximity sensor device's (3) range, which is initially proportional to its conductive element's extension, is considerably increased when the external conductive area (5) is added to the proximity sensor device's (3) internal conductive element (6).

In the preferred embodiment illustrated in Figure 2, the proximity sensor (7) is connected to a printed circuit board or PCB (13). The conductive element (6) is comprised in the aforementioned PCB (13) and reaches the side (14) of the PCB (13) via connection areas (15). Similarly, the conductive area (5) of the structural support (4) also extends in such a way that connection areas (17) reach the side (16) of the structural support (4). Then, when the proximity sensor system (1) is installed, the proximity sensor device (3) is connected to the structural support (4) and the sides (14, 16) make contact. As a consequence, the connection areas (15, 17) are electrically connected to each other and a large effective conductive area is obtained.

For illustrative purposes, Figure 2 depicts other elements the proximity sensor device (3) could be comprised of, such as a power supply (18) or a radio frequency transmitter (19). These elements however are not relevant to this invention.

Preferably, the proximity sensor (7) is a capacitance variation sensor. Capacitance sensors are based on the fact that the presence of any conductive body (as is the case with all living beings) generates a capacitance variation that is detected by the sensor. Because this kind of sensor is currently used in a large number of electronic devices (e.g., touch screens), its components are available on the market at suitable supply volumes, consumption values, sizes and prices.

Preferably, the structural support (4) is a vinyl sheet, which offers several advantages. Firstly, a vinyl sheet is a semi-rigid support that can be adapted to flat surfaces such as a wall or table. Secondly, a vinyl sheet can be easily transported. Also, it can be easily screen-printed and it will easily take conductive ink. Furthermore, it can be standardised, it is light and easily adaptable to paintings, works of art or objects of any size. It is also cheap and thus ensures that the price/quality ratio of the proximity sensor system according to the invention remains high.

Preferably, the conductive area (5) is a printed area that is printed with conductive ink on the structural support (4). A conductive area (5) of this kind can be manufactured at low cost and works on an optimum basis.

Preferably, the structural support (4) is shaped and sized so that it is adapted to the work of art. In Figure 1, where the work of art protected by the proximity sensor system (1) is a painting (2), in other words, is essentially two-dimensional, the structural support (4) is flat, rectangular in shape and is of the same size as the painting (2). Thus the structural support (4) reaches all sides and corners of the painting (2) and therefore the painting (2) is fully protected, not leaving weak spots where an unauthorised person could gain access.

The proximity sensor system (1) according to the invention can be used to detect proximity to other two-dimensional objects, not only paintings. For example, it can be used on a table, display cabinet, doormat, etc. In all of these examples the structural support (4) will normally be two-dimensional, as illustrated in Figure 1. Alternatively, other embodiments of the invention are considered where the structural support (4) is three-dimensional, in other words, not flat, and having a certain volume. This kind of structural support (4) can be useful for protecting three-dimensional works of art such as sculptures. The three-dimensional structural support (4) could be housed and hidden inside the work of art itself. Alternatively, the structural support (4) can also be an essentially one-dimensional element (for example a wire, two stripped wires or any other similar conductive element). In other words, the structural support (4) can be of any shape or size, as long as it is a conductive support or contains a conductive area (5).

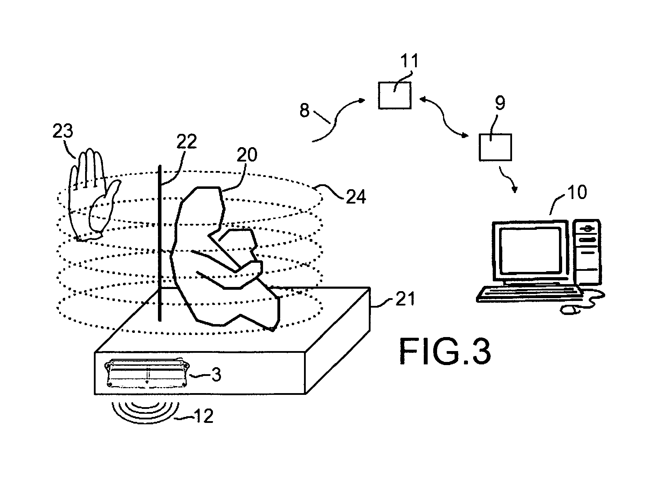

Figure 3 shows a second embodiment of the invention. In this embodiment, the object to be protected is a sculpture (20) mounted on a pedestal or base (21). The proximity sensor device (3) is placed underneath or inside this base (21). Connected to the proximity sensor device (3) there is a wire (22) which operates as the conductive area (5). When a external conductive element such as a hand (23) comes close to the electromagnetic field (24) relating to the wire (22), the proximity sensor device (3) detects the proximity of the hand (23). As a result, the proximity sensor device (3) transmits a radio frequency alarm signal (8) and also emits an alarm sound signal (12). The alarm signal (8), which may contain an identification code relating to the proximity sensor device (3) or any other relevant information (not relevant to the present invention), is received by a relay device (11) that re-transmits the signal to a receiver (9), which in turn re-transmits it to a remote computer (10). In the example in the figure, a structural support (4) is not used. Instead, the wire (22) is fixed to the wall or installed in any other suitable way.

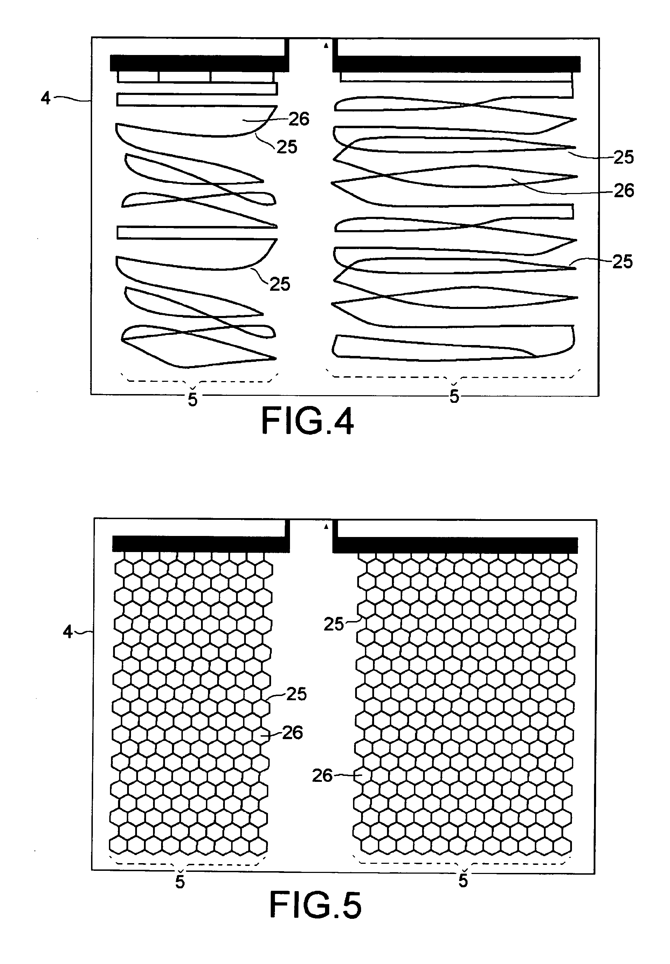

The conductive area (5) can be of any shape or size. But, preferably, the conductive area (5) comprises conductive lines (25) spread out over the structural support (4) defining non-conductive gaps (26) between the lines, as illustrated in Figure 4. This preferred embodiment is cheaper than using large conductive areas. For example, if the conductive area (5) were a fully printed area, it would require a large quantity of ink, which would make the product more expensive and would complicate the printing process (given the viscosity of the ink). If a trace or a line of ink is used instead, almost the whole surface of the structural support (4) can be covered using a minimum amount of ink. The sensor will operate correctly as long as the conductive lines (25) are well designed.

Preferably, the conductive lines (25) form a mesh, as illustrated in Figure 5. The advantage of a mesh is that if the conductive lines (25) are accidentally or voluntarily cut in any area, conductivity is ensured by other areas of the mesh. This means that if the structural support (4) is vinyl or any other kind of support that can be cut, the structural support (4) can be cut in order to obtain the size and shape required, while the conductivity of the conductive area (5) is always maintained.

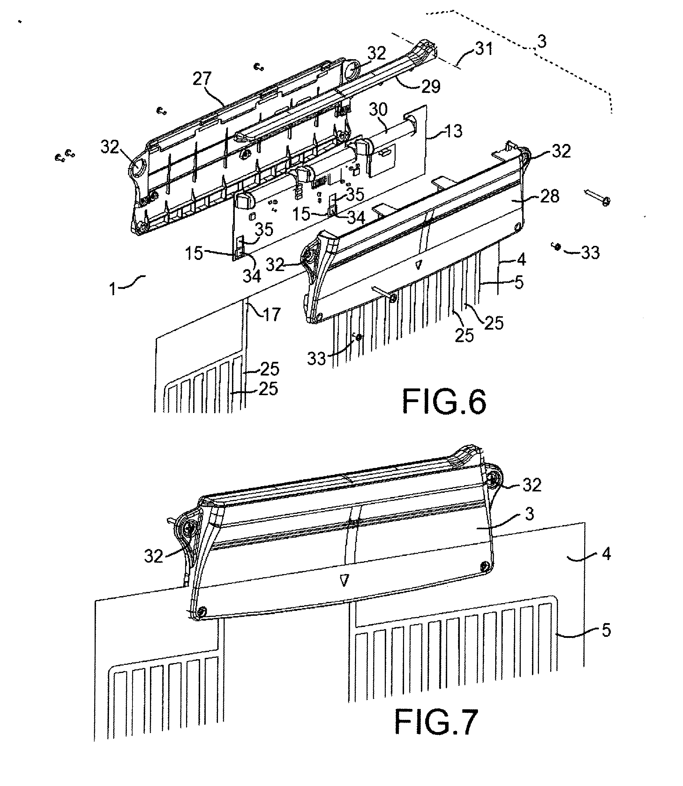

Figure 6 illustrates the preferred embodiment of the proximity sensor system (1) according to the invention, showing the proximity sensor device (3) in an exploded view. This figure shows a flat structural support (4) made out of vinyl, whereby the conductive area (5) is made using a number of conductive lines (25). In the embodiment illustrated in the figure, the proximity sensor device (3) comprises a rear cover (27), a front cover (28) and an upper cover (29). Between the rear cover (27) and the front cover (28) is the PCB (13) comprising the sensor and electronic elements of the proximity sensor device (3). The upper cover (29) can be opened by turning it in accordance with the turning axis (31). Opening the upper cover (29) allows access to the proximity sensor device's (3) back-up batteries (30). The proximity sensor device (3) comprises fixture points (32) to allow the device to be fixed to the wall or to whichever area it is to be installed upon. In the figure, these fixture points (32) are holes where screws or eye bolts can be inserted. The proximity sensor device (3) and the structural support (4) are assembled as follows: between the rear cover (27) and the front cover (28), the proximity sensor device (3) has a hole that is big enough to insert the structural support (4) until the connection areas (17) of the structural support (4) come into contact with the connection areas (15) of the proximity sensor device (3). Then, the proximity sensor device (3) offers certain means to ensure that contact between the connection areas (15, 17) is permanent. Specifically, the proximity sensor device (3) substantially clamps the structural support (4) to ensure a mechanical connection and conductivity. In the diagram, the means to ensure contact are screws (33) that cross, support and press the structural support (4) against the PCB (13), and clamps (34) connected through respective windows (35).

Figure 7 shows the previous proximity sensor system (1) with the proximity sensor device (3) in an assembled view. The proximity sensor device (3) clamps the upper part of the structural support (4), and both of them are located, for example, behind a painting and fixed to the wall using the fixture points (32). In a very cost-efficient way, a connection is achieved between the structural support's large conductive area (5) and the proximity sensor device's (3) internal conductive element (6), not shown. This connection increases the proximity sensor device's (3) range so that it covers the whole painting. The connection between the two (3, 4), preferably using a clamp, is also easy to set up or disconnect.

Another object of the invention is a method of detecting proximity that can be performed by the system in the event that the system comprises a proximity sensor device (3) fitted with at least two conductive elements (6), each one of them connected to an external conductive area (5). The proximity sensor device (3) according to the invention monitors the electrical properties of each conductive unit (5, 6), measuring the difference between the said electrical properties of the conductive units (5, 6) and comparing this differential measurement with a predetermined value using an algorithm of greater or lesser complexity (outside the scope of this invention) in order to determine whether proximity has been detected. This differential measurement offers the advantage of cancelling the noise present in the electrical properties of each conductive unit (5, 6), which is symmetric, in other words, the same in both units (5, 6). Therefore, the detection of proximity based on a differential measurement is much more stable and reliable than detection based on the electrical properties of each separate conductive unit (5, 6), as these are individually affected to a great extent by noise.

Preferably, the proximity sensor (7) is a capacitance variation sensor and the proximity sensor device (3) has at least three conductive elements (6), each of which is connected to a separate external conductive area (5). The capacitance variation sensor measures at least two capacitances, one between the first conductive unit (5, 6) and the second conductive unit (5, 6) and the other between one of these units and the third conductive unit (5, 6). In this case, the method according to the invention measures the difference between both capacitances and compares it with a predetermined value using an algorithm of greater or lesser complexity (outside the scope of this invention) in order to finally determine whether proximity has been detected.

## Claims

1. A proximity sensor system (1) **characterised in that** it comprises:
- a proximity sensor device (3) comprising a proximity sensor (7) which detects electric variations in a conductive element (6),
- a conductive area (5) external to the proximity sensor device (3), whereby said conductive area (5) operates as an extension of the conductive element (6).

2. A proximity sensor system (1), according to claim 1, **characterised in that** the proximity sensor (7) is a capacitance variation sensor.

3. A proximity sensor system (1), according to claim 1, **characterised in that** the proximity sensor device (3) comprises fixture points (32) that allow the device to be fixed to a wall or other area where it is to be installed.

4. A proximity sensor system (1), according to claim 1, **characterised in that** the conductive area (5) is comprised in a structural support (4) that is initially independent of the proximity sensor device (3), the structural support then being connected to the proximity sensor device (3) in such a way that the conductive area (5) is connected to the conductive element (6).

5. A proximity sensor system (1), according to claim 4, **characterised in that** the conductive element (6) is comprised in a PCB (13) of the proximity sensor device (3), the conductive element (6) comprising connection areas (15) that reach a side (14) of said PCB (13), while the structural support's (4) conductive area (5) is disposed so that certain connection areas (17) reach a side (16) of said structural support (4), so that when the proximity sensor device (3) is connected to the structural support (4), the sides (14, 16) come into contact and the connection areas (15, 17) become electrically connected to each other.

6. A proximity sensor system (1), according to claim 4, **characterised in that** the structural support (4) is vinyl.

7. A proximity sensor system (1), according to claim 4, **characterised in that** the conductive area (5) is a printed area that is printed with conductive ink.

8. A proximity sensor system (1), according to claim 4, **characterised in that** the conductive area (5) is substantially made using conductive lines (25) that are arranged on the structural support (4) defining non-conductive gaps (26) between them.

9. A proximity sensor system (1), according to claim 8, **characterised in that** the conductive lines (25) form a mesh.

10. A proximity sensor system (1), according to claim 4, **characterised in that** it is designed to protect an object (2, 20), the shape and/or size of the structural support (4) being fundamentally adapted to the shape and/or size of said object (2, 20).

11. A proximity sensor system (1), according to claim 10, **characterised in that** the structural support (4) is flat.

12. A proximity sensor system (1), according to claim 4, **characterised in that** the connection between the proximity sensor device (3) and the structural support (4) is achieved by inserting the structural support (4) in at least one side of the proximity sensor device (3), in a sort of clamping, and then fixing said structural support (4) so that the connection areas (17) of the structural support (4) become in contact with the connection areas (15) of the proximity sensor device (3).

13. A proximity detection method, performable by a proximity sensor device (3) comprising a proximity sensor (7) that detects electric variations in at least two conductive elements (6), wherein said proximity sensor device (3) is connected to at least two external conductive areas (5) that operate as an extension of the conductive elements (6), **characterised in that** it comprises the action of measuring the difference between the electric variations of each unit (5,6).

14. A proximity detection method, according to claim 13, **characterised in that** the proximity sensor (7) is a capacitance variation sensor, with the proximity sensor device (3) having at least three conductive elements (6) each one connected to an external conductive area (5) in such a way that the capacitance variation sensor measures at least two capacitances, and **in that** the stage of measuring the difference between measured capacitances is performed.
